# EUROPEAN PATENT APPLICATION

(11) **EP 4 831 666 A1**
(43) Date of publication of application: **28.10.2026**
(21) Application number: 25845198.8
(22) Date of filing: 08.07.2025
(51) Int. Cl.: G01R 31/392, G01R 31/396, G01R 31/385, G01R 31/52, G01R 31/367, G01R 19/02, G01R 19/10, G01R 19/12, G01R 19/165

(54) **BATTERY CELL DIAGNOSIS METHOD AND ELECTRONIC DEVICE FOR PERFORMING SAME**

(30) Priority: 26.07.2024 KR 20240099475
(71) Applicant: LG Energy Solution, Ltd., Seoul 07335 (KR)
(72) Inventor: KIM, Kihoon, Daejeon 34122 (KR); JANG, Taehyeok, Daejeon 34122 (KR); JEON, Miyeon, Daejeon 34122 (KR)
(74) Representative: Goddar, Heinz J.
(86) International application number: PCT/KR2025/009899
(87) International publication number: WO 2026/023934

(57) **Abstract**

The present invention comprises an information acquisition interface, a memory, and a processor, wherein the processor acquires a first voltage of each of a plurality of battery cells in an idle state, determines compensation voltage of each of the battery cells on the basis of balancing data, determines a second voltage of each of the battery cells on the basis of the first voltage and the compensation voltage of each of the battery cells, determines a voltage deviation of each of the plurality of battery cells on the basis of a reference voltage and the second voltage of each of the plurality of battery cells, determines the amount of change of the voltage deviation according to a predetermined period with respect to each of the plurality of battery cells, identifies a pattern of the amount of change of the voltage deviation of each of the plurality of battery cells, and diagnoses the state of each of the plurality of battery cells on the basis of a preset diagnosis pattern and the pattern of the amount of change of the voltage deviation of each of the plurality of battery cells.

## Description

### Technical Field

The present disclosure relates to a battery cell diagnostic method and an electronic device for performing the same.

### Background Art

Recently, the demand for portable electronic devices such as notebook computers, video cameras, and mobile phones has increased rapidly. In addition, with the full-scale development of electric vehicles, energy storage batteries, robots, satellites, and the like, active research is being conducted on high-performance battery cells capable of being charged and discharged repeatedly. In particular, when a plurality of batteries are charged or discharged, a process of battery balancing and the like is required to minimize voltage differences between each battery. Accordingly, various research has been in progress for diagnosing a micro internal short circuit of a battery through battery voltage monitoring by calculating a compensation voltage accurately in consideration of a voltage change caused by battery balancing when taking into account a voltage of a battery cell for identifying whether there is a micro internal short circuit in the battery.

### Detailed Description of the Invention

### Technical Goals

Disclosed example embodiments are intended to increase accuracy of battery cell diagnosis by identifying consumption capacity by balancing for each of state-of-charge (SoC) ranges of a plurality of battery cells and determining a compensation voltage in consideration of the consumption capacity when detecting a micro internal short circuit of battery cells.

A technical task to be achieved by an example embodiment of the present disclosure is not limited to the technical task described above, and other technical tasks may be derived from example embodiments described below.

### Technical solutions

According to an example embodiment, an electronic device for performing a battery cell diagnostic method may include an information acquisition interface that acquires voltages of a plurality of battery cells included in a battery pack and balancing data of the plurality of battery cells, a memory that stores one or more instructions, and a processor. The processor may be configured to, when the one or more instructions are executed, acquire a first voltage of each of the plurality of battery cells in an idle state, determine, based on the balancing data of the plurality of battery cells, a compensation voltage of each of the plurality of battery cells, determine, based on the first voltage and the compensation voltage of each of the plurality of battery cells, a second voltage of each of the plurality of battery cells, determine, based on a reference voltage and the second voltage of each of the plurality of battery cells, a voltage deviation of each of the plurality of battery cells, determine, for each of the plurality of battery cells, a voltage deviation change amount according to a predetermined period, check a voltage deviation change amount pattern of each of the plurality of battery cells, and diagnose, based on the voltage deviation change amount pattern of each of the plurality of battery cells and a pre-set diagnostic pattern, a state of each of the plurality of battery cells.

The balancing data may include SoC ranges in which cell balancing of each of the plurality of battery cells is performed, a duration of cell balancing performed in each of the SoC ranges, a cell balancing current for each of the SoC ranges, and a cell balancing capacity for each of the SoC ranges.

The processor may be set to determine the compensation voltage of each of the plurality of battery cells based on a total capacity of the plurality of battery cells, the duration of cell balancing performed in each of the SoC ranges, the cell balancing current for each of the SoC ranges, and an open circuit voltage (OCV) change amount according to an SoC change for each of the SoC ranges.

The second voltage may be a voltage obtained by adding the compensation voltage of each of the plurality of battery cells to the first voltage of each of the plurality of battery cells.

The information acquisition interface may acquire the voltages of the plurality of battery cells and the balancing data for each pre-defined period.

The pre-set diagnostic pattern may include a first diagnostic pattern. The processor may be set to, when the one or more instructions are executed, determine, when a plurality of voltage deviation change amounts of a first battery cell included in the plurality of battery cells are all positive numbers, and when a total sum of the plurality of voltage deviation change amounts of the first battery cell is equal to or greater than a first threshold value, that a voltage deviation change amount pattern of the first battery cell corresponds to the first diagnostic pattern and diagnose an occurrence of a micro internal short circuit in the first battery cell.

The pre-set diagnostic pattern may include a second diagnostic pattern. The processor may be set to, when the one or more instructions are executed, determine, when a plurality of voltage deviation change amounts of a second battery cell included in the plurality of battery cells are greater than a second threshold value, that a voltage deviation change amount pattern of the first battery cell corresponds to the second diagnostic pattern and diagnose the occurrence of the micro internal short circuit in the second battery cell.

The pre-set diagnostic pattern may include a third diagnostic pattern. The processor may be set to, when the one or more instructions are executed, determine, when a plurality of voltage deviation change amounts of a third battery cell included in the plurality of battery cells are all positive numbers, and when at least one voltage deviation change amount of the plurality of voltage deviation change amounts of the third battery cell is equal to or greater than a third threshold value, that a voltage deviation change amount pattern of the third battery cell corresponds to the third diagnostic pattern and diagnose the occurrence of the micro internal short circuit in the third battery cell.

The pre-set diagnostic pattern may include a fourth diagnostic pattern. The processor may be set to, when the one or more instructions are executed, determine, when a plurality of voltage deviation change amounts of a fourth battery cell included in the plurality of battery cells are all positive numbers, and when the plurality of voltage deviation change amounts of the fourth battery cell increase over time, that a voltage deviation change amount pattern of the fourth battery cell corresponds to the first diagnostic pattern and diagnose the occurrence of the micro internal short circuit in the fourth battery cell.

The voltages of the battery cells may be OCV voltages according to an SoC change of the plurality of battery cells, which are measured for each pre-defined period.

The reference voltage may be an average value of the second voltage of each of the plurality of battery cells or one of an average value or a central value of the second voltage of each of the plurality of battery cells.

The voltage deviation may be a difference between the second voltage of each of the plurality of battery cells and the reference voltage.

The predetermined period may correspond to a charge and discharge cycle of the plurality of battery cells.

A diagnostic method for a state of a battery cell may include acquiring a first voltage of each of the plurality of battery cells in an idle state, determining, based on balancing data of the plurality of battery cells, a compensation voltage of each of the plurality of battery cells, determining, based on the first voltage and the compensation voltage of each of the plurality of battery cells, a second voltage of each of the plurality of battery cells, determining, based on a reference voltage and the second voltage of each of the plurality of battery cells, a voltage deviation of each of the plurality of battery cells, determining, for each of the plurality of battery cells, a voltage deviation change amount according to a predetermined period, checking a voltage deviation change amount pattern of each of the plurality of battery cells, and diagnosing, based on the voltage deviation change amount pattern of each of the plurality of battery cells and a pre-set diagnostic pattern, a state of each of the plurality of battery cells.

### Effects of the Invention

According to an example embodiment, one or more of the following effects may be expected.

According to an example embodiment of the present specification, since it is possible to perform a compensation voltage based on a voltage in an idle state and a compensation voltage according to a voltage change rate according to a battery cell capacity change rate by considering a charging time and a charging current for each SoC range when determining a voltage for micro internal short circuit determination, it is possible to determine an accurate compensation voltage even when the voltage change rate according to the battery cell capacity change rate is not constant.

In addition, according to an example embodiment of the present specification, it is possible to identify a trend of a voltage deviation change amount of a battery cell based on the determined compensation voltage, thereby diagnosing a state of each battery cell.

The effects of the present disclosure are not limited to those described above, and other effects not explicitly described may be clearly understood by those skilled in the art from the scope of the claims.

### Brief Description of Drawings

FIG. 1 is an interaction relationship of an electronic device for performing a battery cell diagnostic method according to an example embodiment.
FIG. 2 is a block diagram for describing a configuration of an electronic device according to an example embodiment.
FIG. 3 and FIG. 4 are diagrams for describing a compensation voltage determination process performed by an electronic device according to an example embodiment.
FIG. 5 is a diagram for describing a first diagnostic pattern according to an example embodiment.
FIG. 6 is a diagram for describing a second diagnostic pattern according to an example embodiment.
FIG. 7 is a diagram for describing a third diagnostic pattern according to an example embodiment.
FIG. 8 is a diagram for describing a fourth diagnostic pattern according to an example embodiment.
FIG. 9 is a flowchart for describing a battery cell diagnostic method according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when a component is referred to as "including" another component, the component should not be understood as excluding other components so long as there is no special conflicting description, and the component may include at least one other component. In addition, the terms "unit" and "module", for example, may refer to a component that exerts at least one function or operation, and may be realized in hardware or software, or may be realized by combination of hardware and software.

The expression "at least one of A, B, and C" may indicate the following meaning including: A alone; B alone; C alone; both A and B together; both A and C together; both B and C together; or all three of A, B, and C together.

In the following description, example embodiments of the present disclosure will be described in detail with reference to the drawings so that those skilled in the art can easily carry out the present disclosure. However, the present disclosure may be embodied in many different forms and is not limited to the embodiments described herein.

The following description of example embodiments disclosed in the present disclosure is provided with reference to the accompanying drawings.

In describing the example embodiments, descriptions of technical contents that are well known in the art to which the present disclosure belongs and are not directly related to the present specification will be omitted. This is to more clearly communicate without obscuring the subject matter of the present specification by omitting unnecessary description.

For the same reason, in the accompanying drawings, some components are exaggerated, omitted, or schematically illustrated. In addition, the size of each component does not fully reflect the actual size. The same or corresponding components in each drawing are given the same reference numerals.

Advantages and features of the present disclosure and methods of achieving them will be apparent from the following example embodiments that will be described in more detail with reference to the accompanying drawings. It should be noted, however, that the present disclosure is not limited to the following example embodiments, and may be implemented in various forms. Accordingly, the example embodiments are provided only to disclose the present disclosure and let those skilled in the art know the category of the present disclosure, and the present disclosure is only defined by the category of claims. The same reference numerals or the same reference designators denote the same elements throughout the specification.

At this point, it will be understood that each block of the flowchart illustrations and combinations of flowchart illustrations may be performed by computer program instructions. Since these computer program instructions may be mounted on a processor of a general purpose computer, special purpose computer, or other programmable data processing equipment, those instructions executed through the computer or the processor of other programmable data processing equipment may create a means to perform the functions described in flowchart block(s). These computer program instructions may be stored in a computer usable or computer readable memory that can be directed to a computer or other programmable data processing equipment to implement functionality in a particular manner, and thus computer program instructions stored in the computer usable or computer readable memory can produce an article of manufacture containing instruction means for performing the functions described in the flowchart block(s). Computer program instructions may also be mounted on a computer or other programmable data processing equipment, such that a series of operating steps may be performed on the computer or other programmable data processing equipment to create a computer-implemented process to create a computer or other programmable data. Instructions for performing the processing equipment may also provide steps for performing the functions described in the flowchart block(s).

In addition, each block may represent a portion of a module, segment, or code that includes one or more executable instructions for executing a specified logical function(s). It should also be noted that in some alternative implementations, the functions noted in the blocks may occur out of order. For example, the two blocks shown in succession may in fact be executed substantially concurrently, or the blocks may sometimes be executed in the reverse order, depending on the corresponding function.

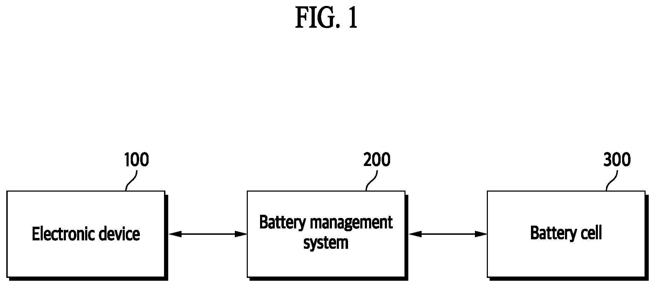

FIG. 1 is an interaction relationship of an electronic device for performing a battery cell diagnostic method according to an example embodiment.

Referring to FIG. 1, the electronic device 100 may operate by interacting with a battery management system 200 that manages a battery cell 300. Here, the battery cell 300 may correspond to the battery cell 300 included in a battery pack, and a plurality of battery cells 300, which are targets to be diagnosed in relation to whether to correspond to battery cells having a micro internal short circuit, may be included therein. Meanwhile, in FIG. 1, only components related to the example embodiment are illustrated. Accordingly, it will be understood by those skilled in the art that, in addition to the components illustrated in FIG. 1, other general-purpose components may also be included. The battery cell 300 according to an example embodiment may include a first battery cell, a second battery cell, a third battery cell, and a fourth battery cell as described below. For example, the first battery cell, the second battery cell, the third battery cell, and the fourth battery cell may be connected in series, and the first battery cell to the fourth battery cell may be connected to the battery management system 200 through a sensing line.

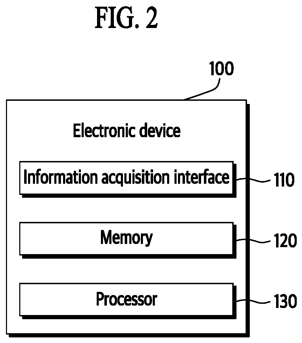

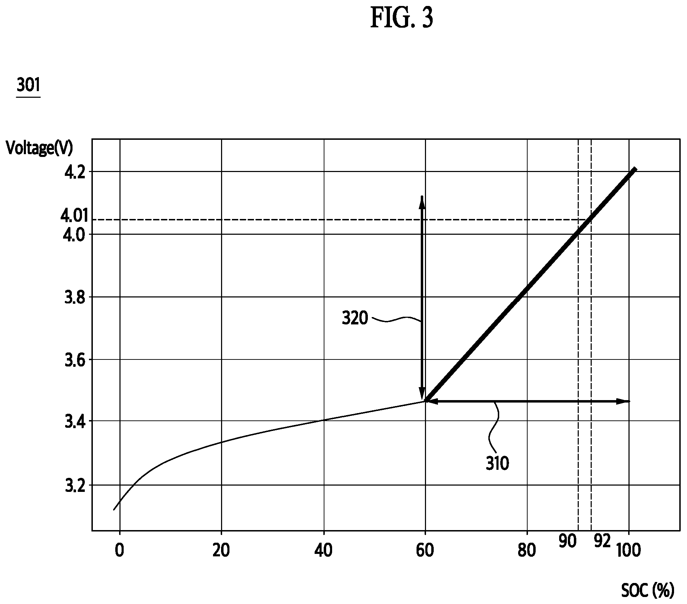

The electronic device 100 according to an example embodiment is a device for configuring and providing information. In an example embodiment, the electronic device 100 may correspond to a server, an analysis device, or a charging device, which receives a parameter related to the battery cell 300 from the battery management system 200 inside a vehicle and instructs the battery management system 200 to perform a balancing method of the battery cell 300 according to the present disclosure. The electronic device 100 may acquire the parameter related to the battery cell 300 from the battery management system 200 and acquire voltages of the plurality of battery cells 300 included in the battery pack and balancing data of the plurality of battery cells 300. The electronic device 100 may acquire a first voltage of each of the plurality of battery cells 300 in an idle state. The voltages of the plurality of battery cells 300 acquired by the electronic device 100 may correspond to OCV voltages according to SoC changes of the plurality of battery cells 300, which are measured for each pre-defined period. The voltages of the plurality of battery cells 300 may refer to voltages of the plurality of battery cells 300 in the idle state after a lapse of a certain period (for example, 10 days) after balancing is performed. The pre-defined period may refer to a single period in which charging and discharging of the battery cell are performed across the entire SoC range. The electronic device 100 may determine a compensation voltage of each of the plurality of battery cells based on balancing data of the plurality of battery cells. The balancing data may include SoC ranges in which cell balancing of each of the plurality of battery cells is performed, a duration of cell balancing performed in each of the SoC ranges, a cell balancing current for each of the SoC ranges, and a cell balancing capacity for each of the SoC ranges. The electronic device 100 may determine the compensation voltage of each of the plurality of battery cells based on a total capacity of the plurality of battery cells, the duration of cell balancing performed in each of the SoC ranges, the cell balancing current for each of the SoC ranges, and an OCV change amount according to an SoC change in each of the SoC ranges, which will be described in detail in FIG. 2 and FIG. 3 below.

According to an example embodiment, the electronic device 100 may determine a second voltage of each of the plurality of battery cells based on the first voltage of each of the plurality of battery cells and the compensation voltage. The second voltage may correspond to a voltage obtained by adding the compensation voltage of each of the plurality of battery cells to the first voltage of each of the plurality of battery cells. The electronic device 100 according to an example embodiment may determine the second voltage of each of the plurality of battery cells by adding all compensation voltages in a plurality of ranges in which cell balancing of the battery cell 300 is performed to the first voltage of each of the plurality of battery cells 300 in an idle state.

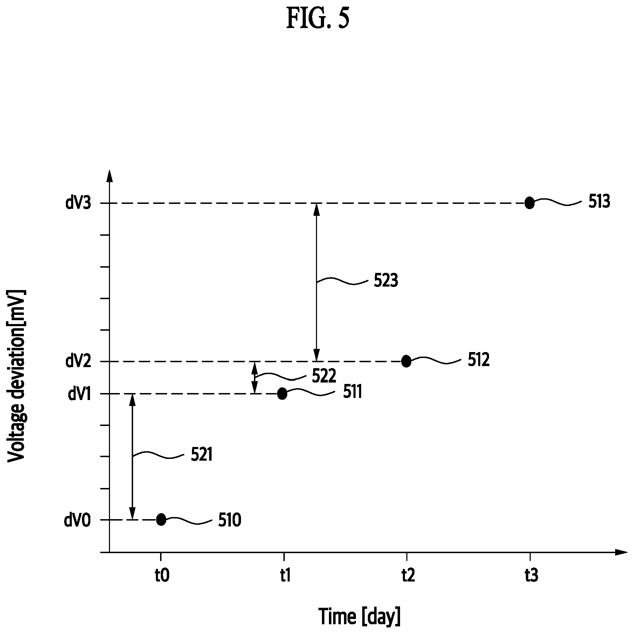

The electronic device 100 according to an example embodiment may determine a voltage deviation of each of the plurality of battery cells based on a reference voltage and the second voltage of each of the plurality of battery cells. The reference voltage may be an average value of the second voltage of each of the plurality of battery cells or one of an average value or a central value of the second voltage of each of the plurality of battery cells. The voltage deviation may correspond to a difference between the second voltage of each of the plurality of battery cells and the reference voltage. According to an example embodiment, the electronic device 100 may determine, for each of the plurality of battery cells, a voltage deviation change amount according to a predetermined period, check a voltage deviation change amount pattern of each of the plurality of battery cells, and diagnose a state of each of the plurality of battery cells based on the voltage deviation change amount pattern of each of the plurality of battery cells and a pre-set diagnostic pattern that will be described in FIGS. 5 to 8 below.

The battery management system 200 may include one or more sensors for measuring a parameter of the battery cell 300, such as a current, a voltage, an initial SoC, internal resistance, an inner temperature, and the like, and include a memory and a processor (not illustrated) for various operations. That is, the battery management system 200 may be operated based on the memory and the processor similarly to the electronic device 100, but may additionally include the sensors, thereby measuring and calculating a parameter of the battery cell 300. In addition, the battery management system 200 may similarly perform overall calculations and simulations performed by the electronic device 100 as briefly described above.

Here, the electronic device 100 and the battery management system 200 may be completely separate individual objects, but may exist separately in a single device or system only conceptually. That is, according to an example embodiment, the electronic device 100 may be coupled to the battery management system 200 in a single vehicle system, acquire balancing data of the battery cell 300 included in an in-vehicle battery, and diagnose a state of each battery cell 300 by considering the compensation voltage of each battery cell 300 according to details that will be described below. That is, a single computing device having a control function for a battery cell may perform all functions of the electronic device 100 and the battery management system 200 that will be described below, and accordingly, such an example embodiment is also considered to fall within the scope of the present disclosure.

FIG. 2 is a block diagram for describing a configuration of an electronic device according to an example embodiment.

Referring to FIG. 2, the electronic device 100 according to an example embodiment may include an information acquisition interface 110, a memory 120, and a processor 130. According to the electronic device 100 illustrated in FIG. 2, only components related to the example embodiment are illustrated. Accordingly, it will be understood by those skilled in the art that, in addition to the components illustrated in FIG. 2, other general-purpose components may also be included.

The information acquisition interface 110 according to an example embodiment may acquire time-series data for a voltage of each of a plurality of battery cells included in the battery cell 300. For example, the information acquisition interface 110 may acquire a voltage value of each battery cell at a specific time interval and acquire time-series data for the voltage value. In other words, the time-series data may be a set of voltage values acquired at a plurality of time points. The information acquisition interface 110 may further acquire data such as a current, a temperature, an SOC, and the like, other than the voltage of the battery cell. When the electronic device 100 that performs a battery cell diagnostic method is a battery management system (BMS) of the battery cell 300, the information acquisition interface 110 may be a component that directly measures the voltage of the battery cell 300, which is, for example, a voltage sensor. In addition, when the electronic device 100 is a vehicle on-board diagnostics device (OBD), a server, a cloud BMS, or a charging and discharging device, the information acquisition interface 110 may be a communication interface that receives voltage information measured from a component (for example, a voltage sensor of the battery cell 300) that measures a voltage of a battery pack. The processor 130 may diagnose a state of each battery cell by analyzing the time-series data acquired from the information acquisition interface 110. Unless otherwise specified, the processor 130 in the present disclosure may refer to a set of one or more processors.

The memory 120 according to an example embodiment may be hardware that stores various data processed in the electronic device 100. The memory 120 may store one or more instructions and store data that has been processed and will be processed through the processor 130 when the one or more instructions are executed. In addition, the memory 120 may store a basic programming and data structure, which may provide a function of at least one example embodiment of the present disclosure, and also store applications (programs, code modules, instructions), drivers, and the like, which may provide a function of an example embodiment of the present disclosure. The memory 120 may include a random access memory (RAM) such as a dynamic random access memory (DRAM) and a static random access memory (SRAM), a read-only memory (ROM), an electrically erasable programmable read-only memory (EEPROM), compact disc read-only memory (CD-ROM), Blu-ray or other optical disk storages, a hard disk drive (HDD), a solid state drive (SSD), or a flash memory, but the example embodiments according to the present disclosure are not limited to the specific cases mentioned.

The one or more processors 130 may control overall operations of the electronic device 100 and process data and signals. The one or more processors 130 may include at least one hardware unit. In addition, the one or more processors 130 may be operated by one or more software modules generated by executing the one or more instructions stored in the memory 120.

Methods implemented as software modules or algorithms may be stored in a computer-readable recording medium as computer-readable codes or program instructions executable by the processor. Here, the computer-readable recording medium may include a magnetic storage medium (e.g., a ROM, a RAM, a floppy disk, a hard disk) and an optical reading medium (e.g., a CD-ROM, a digital versatile disc (DVD)). The computer-readable recording medium may be distributed across computer systems connected through a network, and computer-readable codes may be stored and executed in a distributed manner. The medium may be readable by a computer, stored in the memory, and executed by the processor.

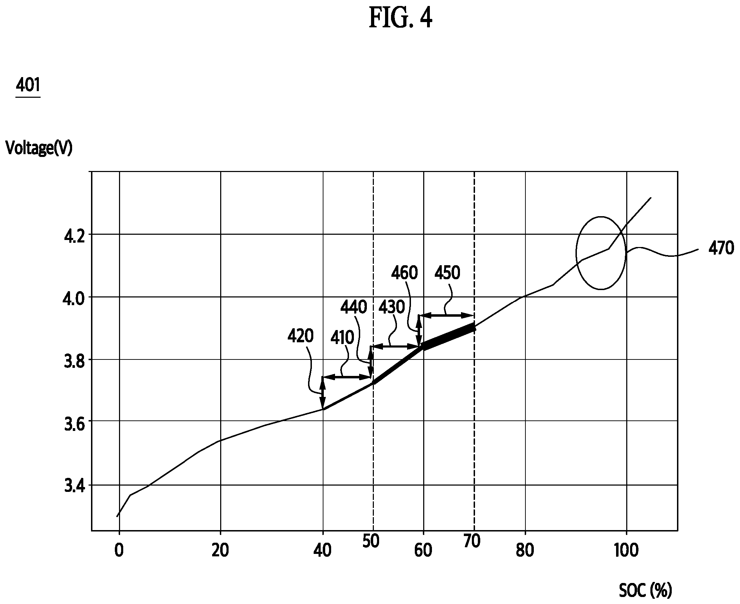

FIG. 3 and FIG. 4 are diagrams for describing a compensation voltage determination process performed by an electronic device according to an example embodiment.

Referring to FIG. 3, the electronic device 100 according to an example embodiment may acquire voltages of a plurality of battery cells included in a battery pack and balancing data of the plurality of battery cells through the above-mentioned information acquisition interface 110. The balancing data may include SoC ranges in which cell balancing of each of the plurality of battery cells is performed, a duration of cell balancing performed in each of the SoC ranges, a cell balancing current for each of the SoC ranges, and a cell balancing capacity for each of the SoC ranges. Balancing-related information may include, for example, a chart 301 including a graph of FIG. 3, which is related to a voltage change amount according to an SoC of a battery cell. The electronic device 100 according to an example embodiment may determine a compensation voltage of the battery cell based on a total capacity of the battery cell, a duration of cell balancing performed in an SoC range 210, a cell balancing current in the SoC range 210, and an OCV change amount according to an SoC change in the SoC range 210. For example, based on a case when a voltage is 4.0 V and an SoC is 90% measured when a first voltage is measured in an idle state after performing balancing, when the total capacity of the battery cell is 100 Ah, the duration of cell balancing performed in the SoC range 210 is 80 hours, and the cell balancing current in the SoC range 210 is 25 mA, the compensation voltage determined by the electronic device 100 may be determined based on Equation 1 below.

[Equation 1] $\begin{matrix}Bcap = Bt X Bc \\ Comv = OCV \left(SoC\left(Cv\right)+\frac{Bcap}{Ccap}X 100\right)\end{matrix}$

In this case, Bcap may denote a cell balancing consumption capacity (Ah) in an SoC range, Bt may denote a duration (h) in which cell balancing is performed, and Bc may denote a cell balancing current (A). In addition, Comv may denote a second voltage determined based on the first voltage and the compensation voltage, SoC(Cv) may denote an SoC corresponding to a voltage in an idle state, and *Ccap* may denote a total capacity of the battery cell.

According to an example embodiment, the second voltage may correspond to a voltage obtained by adding the compensation voltage to the first voltage. For example, in such a case above, since the balancing consumption capacity is 2 Ah, the second voltage may correspond to 4.01 V, which is a voltage when an SoC of the battery cell is 92 %, obtained by adding the compensation voltage of 0.01 V to the first voltage of 4.0 V. Accordingly, the electronic device 100 may determine a voltage deviation of the battery cell based on the second voltage of 4.01 V in which voltage compensation is performed. FIG. 3 is described based on a single battery cell. However, through such a method above, the electronic device 100 according to an example embodiment may determine a voltage deviation change amount of each of a plurality of battery cells for each predetermined period and diagnose a state of each of the plurality of battery cells by comparing a voltage deviation change amount pattern of each of the plurality of battery cells and a pre-set diagnostic pattern.

Referring to FIG. 4, according to an example embodiment, balancing-related information acquired by the electronic device 100 may include, for example, a chart 401 including a graph of FIG. 4, which is related to a voltage change amount according to an SoC of a battery cell. As battery cell voltage change amounts 420, 440, 460 in SoC change ranges 410, 430, 450 of the battery cell are different according to a material composition ratio when the battery cell is manufactured, a degree of a voltage change amount according to an SoC change of the battery cell may be different for each SoC range. For example, in a specific SoC range 470, the degree of the voltage change amount according to the SoC change of the battery cell may be represented as a threshold degree or more. In this case, the electronic device 100 according to an example embodiment may determine a compensation voltage by considering the battery cell voltage change amounts 420, 440, 460 in each of the SoC change ranges 410, 430, 450 and determine a second voltage based on a first voltage of the battery cell in an idle state and the compensation voltage at each of the SoC change ranges.

According to an example embodiment, for example, a duration of battery cell balancing performed in each of the SoC ranges of the battery cell included in balancing data of the battery cell acquired by the electronic device 100 may include Table 1 below.

**[Table 1]**

| SoC (%) | Balancing time (h) |
|---|---|
| 0% to 10% | 0 |
| 10% to 20% | 0 |
| 20% to 30% | 0 |
| 30% to 40% | 0 |
| 40% to 50% | 40 |
| 50% to 60% | 20 |
| 60% to 70% | 20 |
| 70% to 80% | 0 |
| 80% to 90% | 0 |
| 90% to 100% | 0 |

For example, when the first voltage is 4.0 V measured when a voltage of the battery cell is measured in the idle state, and when an SoC is 97 % at this time, the electronic device 100 according to an example embodiment may determine the second voltage based on the compensation voltage at each of the SoC change ranges based on the first voltage of 4.0 V.

For example, as shown in Table 1, when the duration of cell balancing performed in an SoC range of 40% to 50 % of the battery cell is 40 hours with a cell balancing current of 25 mA, a cell balancing capacity of 1 Ah may be consumed. When the duration of balancing performed in an SoC range of 50% to 60% of the battery cell is 20 hours with the balancing current of 25 mA, a balancing capacity of 0.5 Ah may be consumed. When a duration of cell balancing performed in an SoC range of 60% to 70% of the battery cell is 20 hours with the cell balancing current of 25 mA, the balancing capacity of 0.5 Ah may be consumed.

As shown in the chart 401 of FIG. 5, since the battery cell voltage change amounts 420, 440, 460 may be different in each of the SoC change ranges 410, 430, 450, the electronic device 100 according to an example embodiment may determine range-specific compensation voltages in each of the SoC change ranges and determine the second voltage by adding all the range-specific compensation voltages in each of the SoC change ranges to the first voltage of the battery cell in the idle state. For example, the electronic device 100 according to an example embodiment may determine the range-specific compensation voltages in each of the SoC change ranges based on Equation 2 below.
[Equation 2] $Vci = \frac{dvi}{dSoC} X \frac{Bcap}{Ccap} X 100$

In Equation 2, Vci may denote a compensation voltage in a specific SoC range of i, dvi may denote a voltage change amount in the specific SoC range of i, *dSoC* may denote an SoC change amount in the specific SoC range of i, Bcap may denote a cell balancing consumption capacity (Ah), and *Ccap* may denote the total capacity of the battery cell. For example, the voltage change amount in the specific SoC range of i for the SoC change amount in the specific SoC range of i may correspond to a gradient of the graph in each of the SoC change ranges 410, 430, 450.

The electronic device 100 according to an example embodiment may determine the second voltage of the battery cell by adding a sum of the range-specific compensation voltages in each of the SoC change ranges to the first voltage of the battery cell in the idle state.

For example, when a balancing capacity of 1 Ah is consumed in the SoC range of 40% to 50% of the battery cell, since this is an SoC change corresponding to 1 % of 100 Ah that is the total capacity of the battery cell, the electronic device 100 may determine 0.007 (V) corresponding to a voltage change amount for 1 % of the SoC change amount in the SoC range of 40% to 50% as a first compensation voltage in the SoC range of 40% to 50% of the battery cell. For example, when a balancing capacity of 0.5 Ah is consumed in the SoC range of 50% to 60%, since this is an SoC change corresponding to 0.5% of 100 Ah that is the total capacity of the battery cell, the electronic device 100 may determine 0.004 (V) corresponding to a voltage change amount for 0.5% of the SoC change amount in the SoC range of 50% to 60% as a second compensation voltage in the SoC range of 40% to 50% of the battery cell. For example, when a balancing capacity of 0.5 Ah is consumed in the SoC range of 60% to 70%, since this is an SoC change corresponding to 0.5% of 100 Ah that is the total capacity of the battery cell, the electronic device 100 may determine 0.003 (V) corresponding to a voltage change amount for 0.5% of the SoC change amount in the SoC range of 60% to 70% as a third compensation voltage in the SoC range of 40% to 50% of the battery cell.

The electronic device 100 according to an example embodiment may determine the second voltage as 4.014 (V) by adding 0.014 (V), which is a sum of the first compensation voltage to a third voltage compensation degree, to the first voltage of 4.0 V that is measured when a voltage of the battery cell is measured in the idle state.

In this way, the electronic device 100 may perform voltage compensation by considering a voltage change amount according to an SoC change in each of the SoC ranges and perform voltage compensation accurately according to balancing of the plurality of battery cells. Through this, the electronic device 100 may reduce false detection such as a case in which a second voltage is determined as a compensation voltage is determined higher than a required compensation voltage, differently from an actually required compensation voltage, and a case in which a specific battery cell is detected as a battery cell having a micro internal short circuit, although the specific battery cell does not have the micro internal short circuit, in a process of comparing a voltage deviation change amount pattern and a pre-set diagnostic pattern. Hereinafter, an example embodiment of a pre-set diagnostic pattern will be described in detail with reference to FIGS. 5 to 8.

FIG. 5 is a diagram for describing a first diagnostic pattern according to an example embodiment.

For diagnosing a state of each of the plurality of battery cells based on a pre-set diagnostic pattern that will be described hereinafter, it is assumed that the electronic device 100 according to an example embodiment may be provided with a plurality of battery cells determining a second voltage, including a first battery cell, a second battery cell, a third battery cell, and a fourth battery cell.

The electronic device 100 according to an example embodiment may measure first voltages of the plurality of battery cells in an idle state after balancing is performed and acquire a second voltage of each of the battery cells based on the first voltages and the compensation voltages described in FIG. 3 and FIG. 4. The electronic device 100 may acquire the second voltage of the first battery cell as Va, the second voltage of the second battery cell as Vb, the second voltage of the third battery cell as Vc, and the second voltage of the fourth battery cell as Vd. The electronic device 100 may determine voltage deviations for the second voltages in which voltage compensation is performed based on balancing-related information for the first voltages of the plurality of battery cells in the idle state after balancing is performed. More specifically, the electronic device 100 may receive information on voltages of the plurality of battery cells in the idle state after balancing is performed and determine the voltage deviations of the plurality of battery cells based on the compensation voltages, in which voltage compensation is performed according to a voltage compensation degree for the voltages in the idle state.

The electronic device 100 according to an example embodiment may determine reference voltages of the plurality of battery cells. In example embodiments of FIGS. 5 to 8, the electronic device 100 may determine the reference voltages for the compensation voltages of the first battery cell to the fourth battery cell. Each of the reference voltages may be an average value of the second voltage of each of the plurality of battery cells or one of an average value or a central value of the second voltage of each of the plurality of battery cells. For example, the electronic device 100 may determine the reference voltage as Vavg by calculating an equation of "(Va+Vb+Vc+Vd)÷4". The electronic device 100 may determine a reference voltage Vavg for each predetermined period described below. The reference voltage Vavg corresponding to a time point of t1 may be determined based on a plurality of second voltages for the plurality of battery cells acquired at the time point of t1. Likewise, the reference voltage Vavg corresponding to a time point of t2 may be determined based on the plurality of second voltages for the plurality of battery cells acquired at the time point of t2. Accordingly, the reference voltage Vavg corresponding to each time point may be different from one another.

The electronic device 100 according to an example embodiment may determine a voltage deviation of each of the plurality of battery cells by calculating a difference between the determined reference voltage and the second voltage of each of the plurality of battery cells. In other words, the voltage deviation may correspond to the difference between the second voltage of each of the plurality of battery cells and the reference voltage. In example embodiments of FIGS. 5 to 8, the electronic device 100 may determine voltage deviations of a first battery to a fourth battery by calculating second voltages of the first battery to the fourth battery and reference voltages. For example, the electronic device 100 may determine a voltage deviation of the first battery cell as dVa by calculating an equation of "|Va-Vavg|" and determine a voltage deviation of the second battery cell as dVb by calculating an equation of "|Vb-Vavg|". And, the electronic device 100 may determine a voltage deviation of the third battery cell as dVc by calculating an equation of "|Vc-Vavg|" and determine a voltage deviation of the fourth battery cell as dVd by calculating an equation of "|Vd-Vavg|". Here, "∥" denotes an absolute value symbol, and the determined voltage deviation may be represented as an absolute value of a difference between the compensation voltage of each battery cell and the reference voltage.

The electronic device 100 according to an example embodiment may determine a voltage deviation change amount of each of the plurality of battery cells for each predetermined period. For example, the predetermined period may correspond to a charge and discharge cycle of the plurality of battery cells. More specifically, the electronic device 100 may determine the voltage deviation for each of a plurality of batteries for each predetermined period. Here, the voltage deviation may be a voltage deviation of the plurality of battery cells measured in a corresponding period (that is, a time point of compensation voltage measurement of the corresponding period). And, the electronic device 100 may determine the voltage deviation change amount between a voltage deviation determined in a previous period and a compensation voltage deviation determined in a current period. That is, the electronic device 100 may determine the voltage deviation change amount of each of the plurality of battery cells for each predetermined period.

Referring to FIG. 5, the electronic device 100 according to an example embodiment may diagnose a state of each of the plurality of battery cells based on a voltage deviation change amount pattern of each of the plurality of battery cells and a pre-set diagnostic pattern. The pre-set diagnostic pattern may include a first diagnostic pattern to a fourth diagnostic pattern. For example, when a plurality of voltage deviation change amounts 521, 522, 523 for voltage deviations 510, 511, 512, 513 of a specific battery cell at each time point are all positive numbers, and when a sum of the plurality of voltage deviation change amounts 521, 522, 523 is equal to or greater than a pre-set first threshold value, the electronic device 100 may determine that the voltage deviation change amount pattern corresponds to the first diagnostic pattern and diagnose an occurrence of a micro internal short circuit in the specific battery cell. For example, in an example embodiment of FIG. 5, a first voltage deviation change amount 521, a second voltage deviation change amount 522, and a third voltage deviation change amount 523 may all be positive numbers. And, the sum of the first voltage deviation change amount 521, the second voltage deviation change amount 522, and the third voltage deviation change amount 523 may be equal to or greater than the first threshold value, which is, for example, 10 mV. In an example embodiment of FIG. 5, since this is a case in which the determined sum is equal to or greater than the first threshold value, the electronic device 100 may diagnose the occurrence of the micro internal short circuit in the specific battery cell.

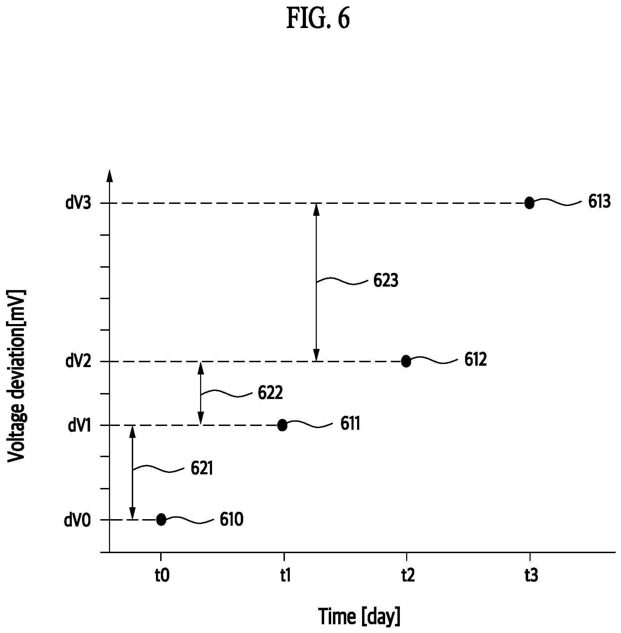

FIG. 6 is a diagram for describing a second diagnostic pattern according to an example embodiment.

Referring to FIG. 6, the electronic device 100 according to an example embodiment may diagnose a state of each of the plurality of battery cells based on a voltage deviation change amount pattern of each of the plurality of battery cells and a second diagnostic pattern. For example, when a plurality of voltage deviation change amounts 621, 622, 623 for voltage deviations 610, 611, 612, 613 of a specific battery cell at each time point are equal to or greater than a second threshold value, the electronic device 100 may determine that the voltage deviation change amount pattern corresponds to the second diagnostic pattern and diagnose an occurrence of a micro internal short circuit in the specific battery cell. For example, in an example embodiment of FIG. 6, a first voltage deviation change amount 621, a second voltage deviation change amount 622, and a third voltage deviation change amount 623 may be positive numbers. And, magnitudes of the first voltage deviation change amount 621, the second voltage deviation change amount 622, and the third voltage deviation change amount 623 may be equal to or greater than the second threshold value. In an example embodiment, the second threshold value may be set to be a value less than the first threshold value. For example, a first threshold value R1 may be set as 10 mV, and the second threshold value may be set as 2 mV. The electronic device 100 may compare each of the first voltage deviation change amount 621, the second voltage deviation change amount 622, and the third voltage deviation change amount 623 with the second threshold value. In an example embodiment of FIG. 6, since the first voltage deviation change amount 621, the second voltage deviation change amount 622, and the third voltage deviation change amount 623 are all equal to or greater than the second threshold value, the electronic device 100 may diagnose the occurrence of the micro internal short circuit in the specific battery cell.

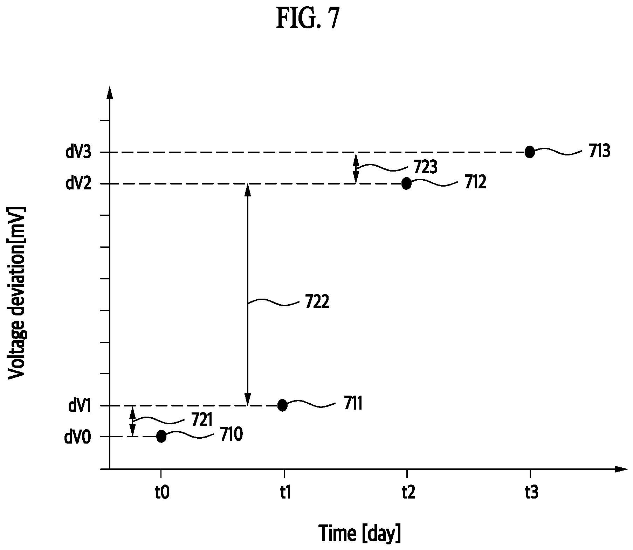

FIG. 7 is a diagram for describing a third diagnostic pattern according to an example embodiment.

Referring to FIG. 7, the electronic device 100 according to an example embodiment may diagnose a state of each of the plurality of battery cells based on a voltage deviation change amount pattern of each of the plurality of battery cells and a third diagnostic pattern. For example, when a plurality of voltage deviation change amounts 721, 722, 723 for voltage deviations 710, 711, 712, 713 of a specific battery cell at each time point are all positive numbers, and when at least one of the plurality of voltage deviation change amounts is equal to or greater than a third threshold value, the electronic device 100 may determine that the voltage deviation change amount pattern corresponds to the third diagnostic pattern and diagnose an occurrence of a micro internal short circuit in the specific battery cell. For example, in an example embodiment of FIG. 7, the first voltage deviation change amount 621, the second voltage deviation change amount 622, and the third voltage deviation change amount 623 may be positive numbers. A magnitude of the second voltage deviation change amount 623 among the first voltage deviation change amount 621, the second voltage deviation change amount 622, and the third voltage deviation change amount 623 may be equal to or greater than the third threshold value. That is, a maximum magnitude of the first voltage deviation change amount 621, the second voltage deviation change amount 622, and the third voltage deviation change amount 623 may be equal to or greater than the third threshold value. In an example embodiment, the third threshold value may be less than the first threshold value pre-set to correspond to the first diagnostic pattern and greater than the second threshold value pre-set to correspond to the second diagnostic pattern. For example, the first threshold value may be set as 10 mV, the second threshold value may be set as 2 mV, and the third threshold value may be set as 6 mV. The electronic device 100 may compare the maximum magnitude of the first voltage deviation change amount 621, the second voltage deviation change amount 622, and the third voltage deviation change amount 623 with the third threshold value. In an example embodiment of FIG. 7, since the second voltage deviation change amount 622 is equal to or greater than the third threshold value, the electronic device 100 may diagnose the occurrence of the micro internal short circuit in the specific battery cell.

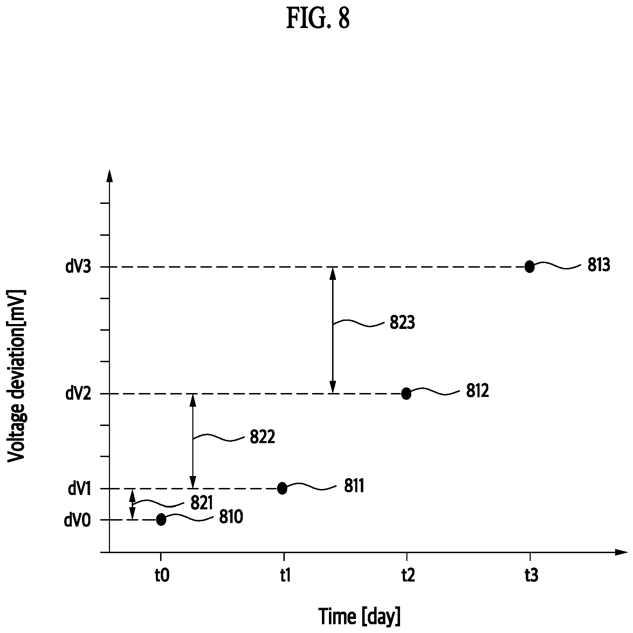

FIG. 8 is a diagram for describing a fourth diagnostic pattern according to an example embodiment.

Referring to FIG. 8, the electronic device 100 according to an example embodiment may diagnose a state of each of the plurality of battery cells based on a voltage deviation change amount pattern of each of the plurality of battery cells and a fourth diagnostic pattern. For example, when a plurality of voltage deviation change amounts 821, 822, 823 for voltage deviations 810, 811, 812, 813 of a second battery cell at each time point are all positive numbers, and when the plurality of voltage deviation change amounts 821, 822, 823 increase over time, the electronic device 100 may determine a pattern of the voltage deviation change amounts 821, 822, 823 corresponds to the fourth diagnostic pattern and diagnose an occurrence of a micro internal short circuit in a specific battery cell. For example, in an example embodiment of FIG. 8, the first voltage deviation change amount 821, the second voltage deviation change amount 822, and the third voltage deviation change amount 823 may have increasing patterns. That is, the first voltage deviation change amount 821, the second voltage deviation change amount 822, and the voltage deviation change amount 823 may increase gradually over time (in other words, with a passage of time points from t1 to t2 to t3). For example, the first voltage deviation change amount 821 may be less than the second compensation voltage deviation change amount 822, and the second voltage deviation change amount 822 may be less than the third voltage deviation change amount 823. The electronic device 100 may determine a voltage deviation change amount pattern of the battery cell as an increasing pattern by comparing magnitudes of the first voltage deviation change amount 821, the second voltage deviation change amount 822, and the third voltage deviation change amount 823 with one another. In an example embodiment of FIG. 8, since the first voltage deviation change amount 821, the second voltage deviation change amount 822, and the third voltage deviation change amount 823 have increasing patterns, the electronic device 100 may diagnose the occurrence of the micro internal short circuit in the specific battery cell.

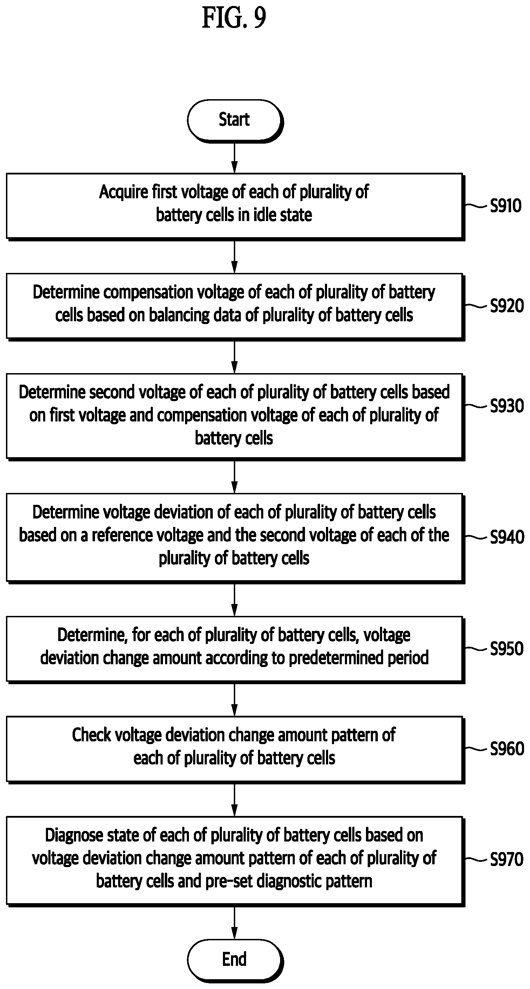

FIG. 9 is a flowchart for describing a battery diagnostic method based on a compensation voltage according to an example embodiment.

Referring to FIG. 9, in operation S910, the electronic device 100 according to an example embodiment may acquire a first voltage of each of the plurality of battery cells in an idle state. The electronic device 100 may acquire the first voltage of each of the plurality of battery cells in the idle state after battery cell balancing is performed through an information acquisition interface that acquires voltages of the plurality of battery cells and balancing data of the plurality of battery cells for each pre-defined period.

In operation S920, the electronic device 100 according to an example embodiment may determine a compensation voltage of each of the plurality of battery cells based on the balancing data of the plurality of battery cells. The balancing data may include SoC ranges in which cell balancing of each of the plurality of battery cells is performed, a duration of cell balancing performed in each of the SoC ranges, a cell balancing current for each of the SoC ranges, and a cell balancing capacity for each of the SoC ranges. In operation S920, the electronic device 100 according to an example embodiment may determine the compensation voltage of each of the plurality of battery cells based on a total capacity of the plurality of battery cells, the duration of cell balancing performed in each of the SoC ranges, the cell balancing current for each of the SoC ranges, and a change amount of an OCV voltage according to an SoC change in each of the SoC ranges.

In operation S930, the electronic device 100 according to an example embodiment may determine a second voltage of each of the plurality of battery cells based on the first voltage of each of the plurality of battery cells and the compensation voltage. The second voltage may be a voltage obtained by adding the compensation voltage of each of the plurality of battery cells to the first voltage of each of the plurality of battery cells. For example, the electronic device 100 may determine the compensation voltage by considering a battery cell voltage change amount in each SoC change range through the process described above in FIG. 3 and FIG. 4 and determine the second voltage based on the first voltage of each battery cell in an idle state and the compensation voltage in each SoC change range.

In operation S940, the electronic device 100 according to an example embodiment may determine a voltage deviation of each of the plurality of battery cells based on a reference voltage and the second voltage of each of the plurality of battery cells. The reference voltage may be an average value of the second voltage of each of the plurality of battery cells or one of an average value or a central value of each of the plurality of battery cells. The voltage deviation of each of the plurality of battery cells may be a difference between the second voltage of each of the plurality of battery cells and the reference voltage.

In operation S950, the electronic device 100 according to an example embodiment may determine, for each of the plurality of battery cells, a voltage deviation change amount according to a predetermined period. The voltage deviation change amount may correspond to a difference between voltage deviations at time points adjacent to one another as described above in FIGS. 5 to 8.

In operation S960, the electronic device 100 according to an example embodiment may check a voltage deviation change amount pattern of each of the plurality of battery cells. The electronic device 100 may check a change pattern of the voltage deviation change amount pattern according to a predetermined period corresponding to a charge and discharge cycle of the plurality of battery cells.

In operation S970, the electronic device 100 according to an example embodiment may diagnose a state of each of the plurality of battery cells based on the voltage deviation change amount pattern of each of the plurality of battery cells and a pre-set diagnostic pattern. As described above in FIGS. 5 to 8, the electronic device 100 may compare the pre-set first diagnostic pattern to fourth diagnostic pattern with the voltage deviation change amount pattern of each of the plurality of battery cells and diagnose, when it is determined that a specific battery cell corresponds to a specific diagnostic pattern, an occurrence of a micro internal short circuit in the specific battery cell. Since the first diagnostic pattern and the fourth diagnostic pattern are different voltage deviation change amount patterns, the electronic device 100 according to an example embodiment may determine, when the voltage deviation change amount pattern of a specific battery cell corresponds to one diagnostic pattern of the first diagnostic pattern to the fourth diagnostic pattern, that the voltage deviation change amount pattern of the battery cell does not correspond to other diagnostic patterns, and thus diagnose an occurrence of a micro internal short circuit in the specific battery cell. The first diagnostic pattern to the fourth diagnostic pattern may be predicated on a case in which a plurality of voltage deviation change amounts are positive numbers. For example, the plurality of voltage deviation change amounts may all be positive numbers. That is, for a battery with the occurrence of the micro internal short circuit, a compensation voltage deviation from other batteries may gradually increase over time. Accordingly, for efficiently using system resources, the electronic device 100 may compare a pattern of the plurality of voltage deviation change amounts with the pre-set diagnostic pattern only for a battery cell in which the plurality of voltage deviation change amounts are all positive numbers.

Meanwhile, disclosed are exemplary embodiments of the present disclosure in the present specification and drawings, it should be understood that specific terms used herein are merely for the purpose of easily describing the technical content of the present disclosure and facilitating understanding of the present disclosure, and are not intended to limit the scope of the present disclosure. It will be apparent to those skilled in the art that, in addition to the embodiments disclosed herein, various modifications based on the technical spirit of the present disclosure may also be implemented.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that components may be executed by software programming or software components, the present example embodiments may be implemented by programming or scripting languages such as C, C++, Java, and assembler language, and Python including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing. The terms "mechanism", "component", "means", and "configuration" may be widely used and are not limited to mechanical and physical elements. These terms may include meaning of a series of routines of software in association with the processor.

The above-described example embodiments are merely examples, and other example embodiments may be implemented within the scope of the following claims.

## Claims

1. An electronic device comprising:
an information acquisition interface configured to acquire voltages of a plurality of battery cells included in a battery pack and balancing data of the plurality of battery cells;
a memory configured to store one or more instructions; and
a processor,
wherein the processor is configured to, when the one or more instructions are executed, acquire a first voltage of each of the plurality of battery cells in an idle state, determine, based on the balancing data of the plurality of battery cells, a compensation voltage of each of the plurality of battery cells, determine, based on the first voltage and the compensation voltage of each of the plurality of battery cells, a second voltage of each of the plurality of battery cells, determine, based on a reference voltage and the second voltage of each of the plurality of battery cells, a voltage deviation of each of the plurality of battery cells, determine, for each of the plurality of battery cells, a voltage deviation change amount according to a predetermined period, check a voltage deviation change amount pattern of each of the plurality of battery cells, and diagnose, based on the voltage deviation change amount pattern of each of the plurality of battery cells and a pre-set diagnostic pattern, a state of each of the plurality of battery cells.

2. The electronic device of claim 1, wherein the balancing data comprises state-of-charge (SoC) ranges in which cell balancing of each of the plurality of battery cells is performed, a duration of cell balancing performed in each of the SoC ranges, a cell balancing current for each of the SoC ranges, and a cell balancing capacity for each of the SoC ranges.

3. The electronic device of claim 1, wherein the processor is configured to determine the compensation voltage of each of the plurality of battery cells based on a total capacity of the plurality of battery cells, a duration of cell balancing performed in each of the SoC ranges, a cell balancing current for each of the SoC ranges, and an open circuit voltage (OCV) change amount according to an SoC change for each of the SoC ranges.

4. The electronic device of claim 1, wherein the second voltage is a voltage obtained by adding the compensation voltage of each of the plurality of battery cells to the first voltage of each of the plurality of battery cells.

5. The electronic device of claim 1, wherein the information acquisition interface is configured to acquire a voltage of the plurality of battery cells and the balancing data for each pre-defined period.

6. The electronic device of claim 1, wherein the pre-set diagnostic pattern comprises a first diagnostic pattern, and
wherein the processor is configured to, when the one or more instructions are executed, determine, when a plurality of voltage deviation change amounts of a first battery cell included in the plurality of battery cells are all positive numbers, and when a total sum of the plurality of voltage deviation change amounts of the first battery cell is equal to or greater than a first threshold value, that a voltage deviation change amount pattern of the first battery cell corresponds to the first diagnostic pattern and diagnose an occurrence of a micro internal short circuit in the first battery cell.

7. The electronic device of claim 1, wherein the pre-set diagnostic pattern comprises a second diagnostic pattern, and
wherein the processor is configured to, when the one or more instructions are executed, determine, when a plurality of voltage deviation change amounts of a second battery cell included in the plurality of battery cells are equal to or greater than a second threshold value, that a voltage deviation change amount pattern of the first battery cell corresponds to the second diagnostic pattern and diagnose an occurrence of a micro internal short circuit in the second battery cell.

8. The electronic device of claim 1, wherein the pre-set diagnostic pattern comprises a third diagnostic pattern, and
wherein the processor is configured to, when the one or more instructions are executed, determine, when a plurality of voltage deviation change amounts of a third battery cell included in the plurality of battery cells are all positive numbers, and when at least one voltage deviation change amount of the plurality of voltage deviation change amounts of the third battery cell is equal to or greater than a third threshold value, that a voltage deviation change amount pattern of the third battery cell corresponds to the third diagnostic pattern and diagnose an occurrence of a micro internal short circuit in the third battery cell.

9. The electronic device of claim 1, wherein the pre-set diagnostic pattern comprises a fourth diagnostic pattern, and
wherein the processor is configured to, when the one or more instructions are executed, determine, when a plurality of voltage deviation change amounts of a fourth battery cell included in the plurality of battery cells are all positive numbers, and when the plurality of voltage deviation change amounts of the fourth battery cell increase over time, that a voltage deviation change amount pattern of the fourth battery cell corresponds to the first diagnostic pattern and diagnose an occurrence of a micro internal short circuit in the fourth battery cell.

10. The electronic device of claim 1, wherein the voltages of the battery cells are OCVs according to an SoC change of the plurality of battery cells, which are measured for each pre-defined period.

11. The electronic device of claim 1, wherein the reference voltage is an average value of the second voltage of each of the plurality of battery cells or one of an average value or a central value of the second voltage of each of the plurality of battery cells.

12. The electronic device of claim 1, wherein the voltage deviation is a difference between the second voltage of each of the plurality of battery cells and the reference voltage.

13. The electronic device of claim 1, wherein the predetermined period corresponds to a charge and discharge cycle of the plurality of battery cells.

14. A non-transitory computer-readable recording medium comprising a program for executing, by an electronic device, a method of one of claim 1 to claim 13.

15. A diagnostic method for a state of a battery cell, comprising:
acquiring a first voltage of each of a plurality of battery cells in an idle state;
determining, based on balancing data of the plurality of battery cells, a compensation voltage of each of the plurality of battery cells;
determining, based on the first voltage and the compensation voltage of each of the plurality of battery cells, a second voltage of each of the plurality of battery cells;
determining, based on a reference voltage and the second voltage of each of the plurality of battery cells, a voltage deviation of each of the plurality of battery cells;
determining, for each of the plurality of battery cells, a voltage deviation change amount according to a predetermined period;
checking a voltage deviation change amount pattern of each of the plurality of battery cells; and
diagnosing, based on the voltage deviation change amount pattern of each of the plurality of battery cells and a pre-set diagnostic pattern, a state of each of the plurality of battery cells.
